Europäisches Patentamt

European Patent Office

Office européen des brevets

(19)

(11) Veröffentlichungsnummer: **0 270 185 B1**

(12) **EUROPÄISCHE PATENTSCHRIFT**

(45) Veröffentlichungstag der Patentschrift: 27.02.91

(51) Int. Cl.⁵: **H04Q 3/52**, H04Q 1/16

(21) Anmeldenummer: 87202360.1

(22) Anmeldetag: 30.11.87

(54) Breitband-Raumvielfachkoppelfeld mit Zwischenleitungsführung in einer Leiterplatte mit mehrlagigen Leiterbahnen in Mikrostrip-Technik.

(30) Priorität: 02.12.86 DE 3641149

(43) Veröffentlichungstag der Anmeldung:
08.06.88 Patentblatt 88/23

(45) Bekanntmachung des Hinweises auf die
Patenterteilung:
27.02.91 Patentblatt 91/09

(84) Benannte Vertragsstaaten:
DE FR GB SE

(56) Entgegenhaltungen:
EP-A- 0 037 882
US-A- 3 878 341

PATENT ABSTRACTS OF JAPAN, Seite 2038
E 76; & JP-A-61 134 006 (HITACHI SEISAKUS-
HO KK) 20-11-1976

(73) Patentinhaber: Philips Patentverwaltung
GmbH
Wendenstrasse 35 Postfach 10 51 49
D-2000 Hamburg 1(DE)DE

Patentinhaber: N.V. Philips' Gloeilampenfabrieken
Groenewoudseweg 1
NL-5621 BA Eindhoven(NL)FR

(72) Erfinder: Jasmer, Wolfgang, Ing. grad.
Dachsberg 13b
D-2000 Hamburg 61(DE)
Erfinder: Killat, Ulrich, Dr.
Achter Lüttmoor 2c
D-2000 Hamburg 56(DE)
Erfinder: Krüger, Johann, Dipl.-Ing.
Alter Hof 3
D-2085 Quickborn(DE)

(74) Vertreter: Peuckert, Hermann, Dipl.-Ing. et al
Philips Patentverwaltung GmbH Wendenstrasse 35 Postfach 10 51 49
D-2000 Hamburg 1(DE)

**Beschreibung**

Breitband-Raumvielfachkoppelfeld mit Zwischenleitungsführung in einer Leiterplatte mit mehrlagigen Leiterbahnen in Mikrostrip-Technik

Die Erfindung betrifft ein Breitband-Raumvielfachkoppelfeld mit Zwischenleitungsführung in einer Leiterplatte gemäß dem Oberbegriff des Patentanspruchs 1.

Die Verdrahtung eines mehrstufigen Raummultiplex-Koppelfelds wird unter Verwendung einer kanonischen Zwischenleitungsführung (canonical linkage) vorgenommen. Hierunter versteht man eine spezielle Form der einfachen und vollständigen Zwischenleitungsführung in zweistufigen Koppelgruppen, bei der von jedem Koppelvielfach der ersten Koppelstufe jeweils der n-te Ausgang mit dem n-ten Koppelvielfach der zweiten Koppelstufe verbunden ist.

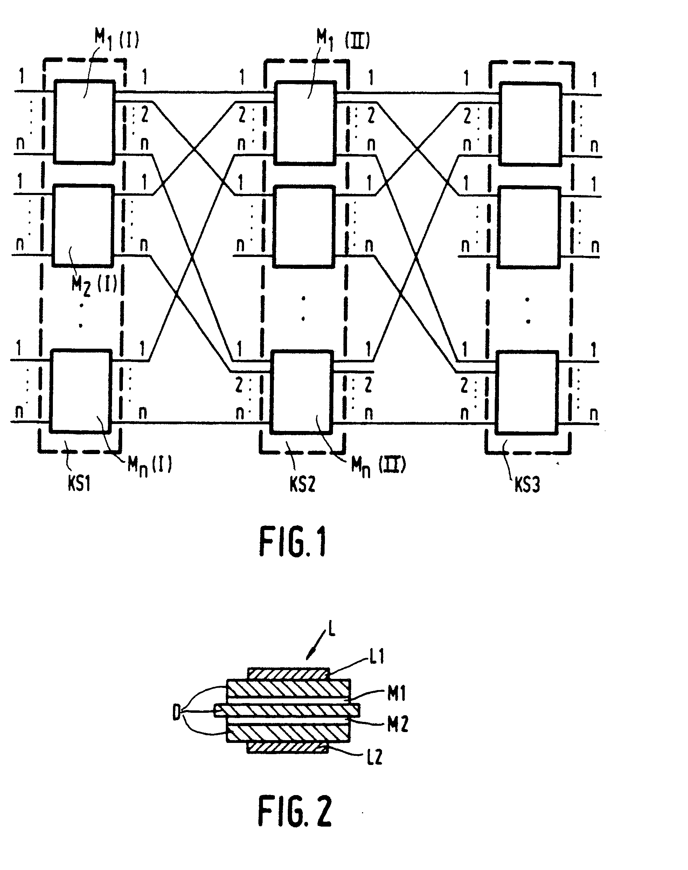

Dieses Verdrahtungsschema der Koppelvielfache (switching matrix) ist in Fig. 1 dargestellt. Die n Ausgänge des Koppelvielfachs $M_1(I)$ der ersten Koppelstufe KS1 werden nacheinander mit jeweils den ersten Eingängen der Koppelvielfache $M_1(II)$ bis $M_n(II)$ der zweiten Koppelstufe KS2 verbunden. In gleicher Weise werden die n Ausgänge des Koppelvielfachs $M_2(I)$ der ersten Koppelstufe KS1 mit jeweils den zweiten Eingängen der Koppelvielfache $M_1(II)$ bis $M_n(II)$ der zweiten Koppelstufe verbunden usw., bis schließlich die n Ausgänge des Koppelvielfachs $M_n(I)$ der ersten Koppelstufe KS1 mit jeweils dem n-ten Eingang der Koppelvielfache $M_1(II)$ bis $M_n(II)$ der zweiten Koppelstufe KS2 verbunden sind. Bei einem mehrstufigen Koppelfeld wird die gleiche Verdrahtung zwischen den nachfolgenden Koppelstufen vorgenommen.

Hierzu sind bei einem Koppelfeld mit 256 Ein- und Ausgängen, Verwendung von Koppelvielfachen mit 16 Ein- und Ausgängen und kanonischer Zwischenleitungsführung, 256 Zwischenleitungen zwischen den einzelnen Koppelstufen erforderlich. Die Übertragung von Signalen mit hoher Bitrate (z.B. 140 Mbit/s) bedingt die Verwendung teurer Koaxialkabel, wobei - infolge der angestrebten Bitgenauigkeit für unterschiedliche Signalwege - die Leitungslängen der Zwischenleitungen eng toleriert werden müssen.

Diese konventionelle Verdrahtung mittels Koaxialkabel erfordert einen hohen Fertigungsaufwand und einen hohen Raumbedarf für Koppelfeld und Koppelnetz.

Zur Reduzierung des Raumbedarfs wird deshalb in zunehmendem Maße die Verdrahtung der Koppelvielfache benachbarter Koppelstufen unter Verwendung einer Mehrschicht-Leiterplatte durchgeführt. Aus ntz Band 39 (1986) Heft 5, Seiten 312 bis 316, insbesondere Seite 315, ist ein Koppelfeldbaustein für 140 Mbit/s in CMOS-Technologie bekannt, bei dem die Verdrahtung der Koppelvielfache benachbarter Koppelstufen mit 64 Ein- und Ausgängen mittels einer sechslagigen Leiterplatte (multilayerplatine) vorgenommen wird.

Aus JP-A-51 134 006 ist eine Anordnung mit einer Eingangskoppelstufe aus mehreren Koppelvielfachen und mit einer Ausgangskoppelstufe mit einer entsprechenden Anzahl von Koppelvielfachen bekannt, wobei die Ausgänge der Eingangskoppelstufe mit den Eingängen der Ausgangskoppelstufe durch kanonisch geführte Zwischenleitungen verbunden sind. Die Koppelvielfache der Eingangskoppelstufe und die Koppelvielfache der Ausgangskoppelstufe befinden sich auf jeweils einer Seite einer Leiterplatte, wobei die Anschlüsse der Koppelvielfache matrixartig angeordnet sind. Eine Spalte wird gebildet durch die Anschlüsse eines Koppelvielfaches und eine Zeile wird gebildet durch die gleichrangigen Anschlüsse der verschiedenen Koppelvielfache. Die Zwischenleitungen sind zwischen den jeweiligen Anschlüssen auf jeweils einer Seite der Leiterplatte geführt, sie weisen unterschiedliche Längen auf.

Weiterhin ist in einem Aufsatz zu einem auf der NTG-Fachtagung vom 25. bis 27 März 1985 gehaltenen Vortrag ("Konzeption und Realisierung eines Breitband-Koppelnetzes für 70 Mbit/s" von K.T. Langer et al, abgedruckt in "Wege zum integrierten Kommunikationsnetz", Vorträge der NTG-Fachtagung vom 25. bis 27. März 1985 in Berlin, VDE-Verlag GmbH) ein Breitband-Koppelnetz vorgestellt worden, bei dem die Verdrahtung der Koppelvielfache benachbarter Koppelstufen mittels einer 17-lagigen Leiterplatte vorgenommen wird. Die einzelnen Koppelstufenumfassen bei der dort vorgestellten Ausführungsform auf jeder Leiterplatte 16 Koppelvielfache mit jeweils 16 Ein- und Ausgängen, so daß zwischen den einzelnen Leiterplatten 256 Zwischenleitungen erforderlich sind.

Im Hinblick auf eine geringe Verlustleistung für das Breitband-Koppelnetz sind möglichst kurze Verbindungsleitungen erforderlich, so daß die Leiterplatten der dritten Stufe des fünfstufigen Koppelfelds zu denen der anderen Stufen um 90° gedreht sind. Die Entkopplung der Zwischenleitungen wird mittels der Multilayer-Verdrahtung in Stripline-Technik (Leitung zwischen zwei Masseebenen mit definiertem Wellenwiderstand) vorgenommen. Auf den Leiterplatten sind die Koppelvielfache paarweise aufgebaut, so daß sich die Anzahl der Stripline-Anordnungen auf acht und die der Schichten auf 17 reduziert. Infolge des gewählten relativ hohen Wellenwiderstands (Vorteil einer geringeren mittleren Verlustleistung und einerreflexionsärmeren Anpassung) liegen die Maße der dort beschriebenen Mehrschicht-Leiterplatte bei einer Höhe von 13 mm, Breite von 15 mm und Länge von 400 mm.

Mit zunehmender Zahl von Zwischenleitungen zwischen den Koppelvielfachen benachbarter Koppelstufen erhöhen sich die fertigungstechnischen Schwierigkeiten bei der Herstellung einer Mehrschicht-Leiterplatte. Dies erklärt sich dadurch, daß - für die Verbindung der einzelnen Schichten - Bohrungen durch die Mehrschicht-Leiterplatte mit hoher Genauigkeit durchgeführt werden müssen und daß auch die zusätzliche Abscheidung von beispielsweise Kupfer nach dem Bohren der Löcher zusätzliche Schwierigkeiten mit sich bringt. Dem Integrationsgrad der Koppelvielfache sind somit, durch die Schwierigkeit der Heranführung der Zwischenleitungen an die Koppelvielfache, fertigungstechnische Grenzen gesetzt.

Der Erfindung liegt die Aufgabe zugrunde, ein Breitband-Raumvielfachkoppelfeld mit Zwischenleitungsführung in einer Leiterplatte mit mehrlagigen Leiterbahnen in Mikrostrip-Technik derart anzugeben, daß diese fertigungstechnisch einfach herstellbar ist und welche einen geringen Raumbedarf erfordert.

Diese Aufgabe wird erfindungsgemäß durch ein Breitband-Raumvielfachkoppelfeld mit den Merkmalen des Patentanspruchs 1 gelöst.

Die erfindungsgemäße Verdrahtung eines Breitband-Raumvielfachkoppelfeldes ist fertigungstechnisch einfach herzustellen und erfordert, durch die Auffächerung der zu Gruppen zusammengefaßten Zwischenleitungsabschnitte des Koppelvielfachs auf eine Schicht der Leiterplatte, nur einen geringen erhöhten Raumbedarf (Im Vergleich zu einer 2n + 1-lagigen Leiterplatte).

Wird gemäß der Ausführungsform für das Breitband-Raumvielfachkoppelfeld nach Patentanspruch 2 eine Leiterplatte mit zwei Leiterbahnebenen verwendet, so kann auf einfache Art und Weise auch für eine hohe Anzahl von Zwischenleitungen ein kreuzungsfreier Aufbau hergestellt werden, wobei sich die Leitungslänge der Zwischenleitungen nur geringfügig erhöht.

Die Ausführungsform des Breitband-Raumvielfachkoppelfeldes nach Patentanspruch 3 weist den Vorteil auf, daß auf einfache Art und Weise gleiche Leitungslängen der Zwischenleitungen erzielt werden.

Die Ausführungsform des Breitband-Raumvielfachkoppelfeldes nach Patentanspruch 5 (daß die Leiterplatte mindestens zweiteilig ausgeführt ist), weist den zusätzlichen Vorteil auf, daß im Störungsfall nur das defekte Leiterplattenteil auszutauschen ist, wodurch die Ersatzteilkosten erheblich reduziert werden können. Weiterhin ist von Vorteil, daß - durch entsprechende Anordnung der Leiterplattenteile zueinander - eine Verringerung der Außenmaße in einer Ebene, falls erforderlich, vorgenommen werden kann. Die Unterteilung der Leiterplatte bringt zudem den Vorteil mit sich, daß der Ausschuß bei der Fertigung gering ist.

Sind zur Verbindung der Leiterplattenteile gemäß Patentanspruch 6 Steckverbindungen vorgesehen, so können die Austauschzeiten für defekte Leiterplattenteile reduziert werden.

Die Erfindung wird im folgenden anhand in der Zeichnung dargestellter Ausführungsformen näher beschrieben und erläutert. Es zeigt:

Fig. 1    schematisch eine kanonische Zwischenleitungsführung,

Fig. 2    die Ausgestaltung einer Leiterplatte mit zweilagigen Leiterbahnen,

Fig. 3    eine erste Ausführungsform der kanonischen Zwischenleitungsführung unter Verwendung einer Leiterplatte mit zweilagigen Leiterbahnen,

Fig. 4    eine zweite Ausführungsform der kanonischen Zwischenleitungsführung mit abschnittsweiser gleicher Leitungslänge der Zwischenleitungen und

Fig. 5    ein Breitband-Raumvielfachkoppelfeld gemäß der Erfindung in Schnittdarstellung.

Die in Fig. 1 dargestellte kanonische Zwischenleitungsführung wurde bereits weiter oben näher erläutert. Der n-te Ausgang des Koppelvielfachs $M_n(I)$ der ersten Koppel stufe KS1 ist mit dem n-ten Eingang des Koppelvielfachs $M_n(II)$ der zweiten Koppelstufe KS2 verbunden, usw..

In Fig. 2 ist die Ausgestaltung einer Leiterplatte L mit zweilagigen Leiterbahnen in Mikrostrip-Technik in Schnittdarstellung angegeben. Zwischen oberer Leiterbahnebene L1 und unterer Leiterbahnebene L2 sind abwechselnd jeweils Schichten des Dielektrikums D und Masseschichten M1 bzw. M2 angeordnet. Mikrostrip-Technik bedeutet in diesem Zusammenhang, daß jeweils z.B. Leiterbahn L1, Dielektrikum D und Masseschicht M1 zusammengehörig sind. Fertigungstechnisch werden die so gebildeten Mikrostrip (L1, D, M1 bzw. L2, D, M2) mit Hilfe einer Zwischenlage (Dielektrikum D) miteinander verklebt. Durch die Abschirmfunktion der Masseschichten M1 bzw. M2 wird die gegenseitige Störbeeinflußung in den Zwischenleitungen der Leiterbahnebenen L1 und L2 durch Störstrahlung vermieden.

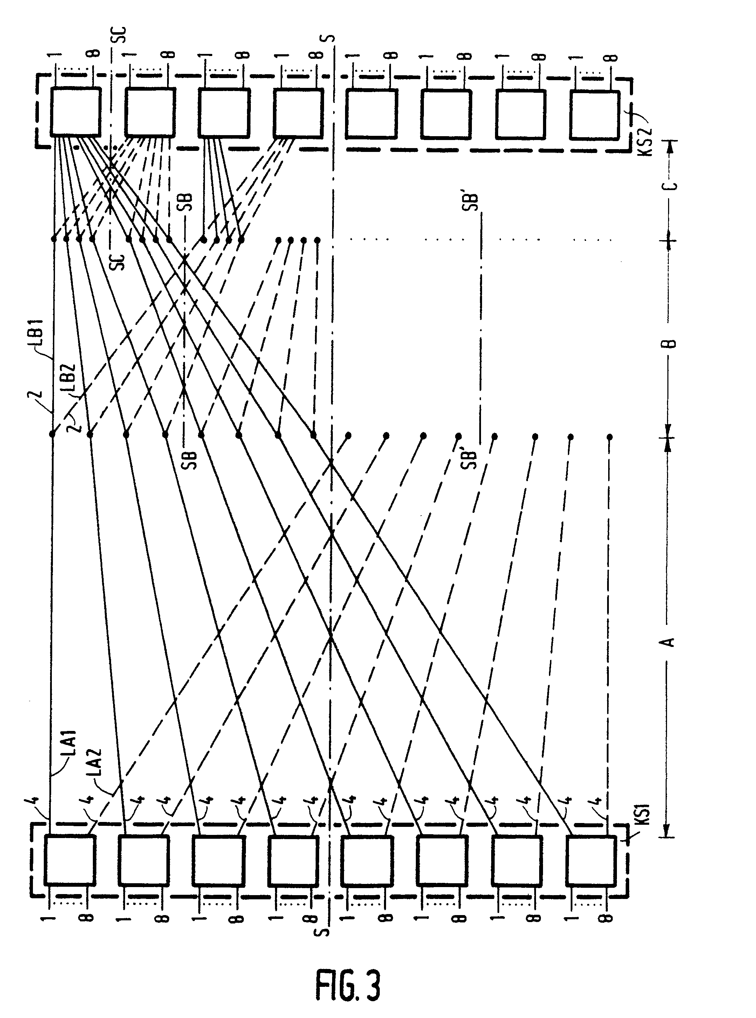

In Fig. 3 ist eine erste Ausführungsform der kanonischen Zwischenleitungsführung unter Verwendung der Leiterplatte L mit zwei Leiterbahnebenen L1 und L2 schematisch dargestellt. In Abhängigkeit von der Zahl der Ausgangsleitungen je Koppelvielfach erhält man in Abschnitte unterteilte Leitungsbündel LA1 bzw. LA2, wobei das Leitungsbündel LA1 der oberen Leiterbahnebene L1 (durchgezogene Linie) und das Leitungsbündel LA2 der unteren Leiterbahnebene L2 (gestrichelte Linie) zugeordnet ist. Die in Fig. 3 dargestellte Ausführungsform weist 64 Ein- und Ausgänge der einzelnen Koppelstufen KS1 bzw. KS2 auf, wobei die einzelnen Koppelvielfache selbst 8 Ein- und Ausgänge aufweisen.

Im Abschnitt A erfolgt die Aufteilung jedes Koppelvielfachs in zwei Gruppen entsprechend der Anzahl von Leiterbahnebenen sowie die Zusammenfassung der Gruppen, welche der oberen bzw. unteren Leiterbahnebene L1 bzw. L2 zugeordnet sind. Im Abschnitt B wiederholen sich Auffächerung in die beiden Leiterbahnebenen L1 und L2 sowie die Zusammenfassung der Leitungsbündel LB1 bzw. LB2 usw.. Im Abschnitt C sind die einzelnen Leitungsbündel schließlich zu einzelnen Zwischenleitungen aufgefächert, wodurch die kanonische Zwischenleitungsführung vollzogen ist.

Fig. 3 zeigt, daß zwischen erstem Koppelvielfach der ersten Koppelstufe KS1 und zweitem bis n-tem Koppelvielfach der zweiten Koppelstufe KS2 eine Verlängerung der Zwischenleitungen im Vergleich zur bekannten Zwischenleitungsführung auftritt. Diese Verlängerung bringt den Vorteil mit sich, daß die einzelnen Zwischenleitungen nur geringfügige Unterschiede in der Leitungslänge aufweisen, so daß annähernd gleiche Signalwege im Breitband-Raumvielfachkoppelfeld auftreten.

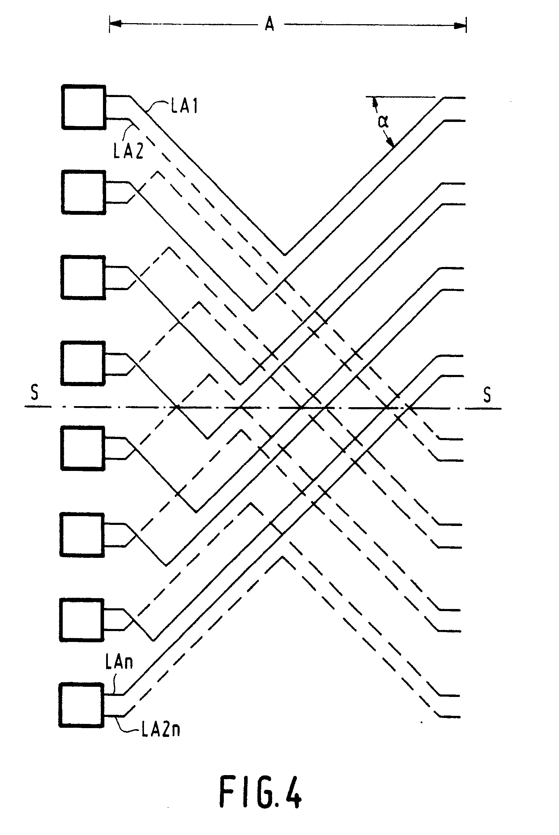

Die Zahl der erforderlichen Abschnitte hängt von der Anzahl der Ausgangsleitungen eines Koppelvielfachs ab. Für $2^n$-Ausgänge je Koppelvielfach sind n Leitungsabschnitte erforderlich, wenn zwei Leiterbahnebenen L1, L2 zur Verfügung stehen. Die oberen bzw. unteren Leiterbahnebenen L1 bzw. L2 sind in Fig. 3 bzw. Fig. 4 durch ausgezogenen bzw. gestrichelte Linie für die einzelnen Zwischenleitungen dargestellt.

Fig. 4 zeigt eine Ausführungsform für eine kanonische Zwischenleitungsführung mit abschnittsweiser gleicher Leitungslänge der Zwischenleitungen. Von dem Leitungsbündel LAn mit der größten Länge und geradlinigem Verlauf ausgehend werden alle übrigen Leitungsbündel LAn-1,... LA1 der Leiterbahnebene L1 kreuzungsfrei und parallel zueinander so angeordnet, daß diese die gleiche Leitungslänge wie das Leitungsbündel LAn aufweisen.

Dieses Faltungsmuster wiederholt sich bezüglich der Symmetrieebene S-S, gespiegelt für die zweite Leiterbahnebene L2 mit den Leitungsbündeln LA2,...LA2n.

Die Faltungsmuster bezüglich der Symmetrielinie S-S wiederholen sich auch in den nachfolgenden Abschnitten B und C (vgl. Fig. 3), wobei im Abschnitt B die Leitungsbündel in beiden Leiterbahnebenen oberhalb und unterhalb der Symmetrielinie S-S kongruent zueinander sind. Daneben sind im Abschnitt B die Faltungsmuster für jede Leiterbahnebene spiegelbildlich zu den Symmetrielinien SB-SB und SB'-SB'. Für den Abschnitt C ergibt sich eine vierfache Wiederholung des Faltungsmusters in vertikaler Richtung und eine Spiegelung der Einzelebenen an der Symmetrielinie SC-SC.

In jedem Abschnitt verlaufen also zur Erzielung gleicher Leitungslänge die Zwischenleitungen kreuzungsfrei und bis auf eine Zwischenleitung gekrümmt. Entsprechend dem längsten Zwischenleitungsabschnitt (Abschnitt A) verkürzen sich die Zwischenleitungslängen in den nachfolgenden Abschnitten B und C. Schließt die in jeder Leiterbahnebene geradlinig verlaufende Zwischenleitung bezüglich der Horizontalen den Winkel $\alpha$ ein und wird dieser Winkel $\alpha$ in den nachfolgenden Abschnitten B und C beibehalten, so halbieren sich die entsprechenden Zwischenleitungslängen.

In Abhängigkeit von der Zahl der Ausgangsleitungen eines Koppelvielfachs reihen sich mehrere Zwischenleitungsabschnitte A, B, C, D usw. aneinander. Die erforderliche Fläche zur Aufnahme der Verdrahtung ist bei Beschränkung auf zwei Leiterbahnebenen relativ groß. Durch Erhöhung des Winkels $\alpha$ kann auf überraschend einfache Art und Weise eine Verkürzung der Abschnitte erzielt werden. Hierbei ist lediglich zu beachten, daß wegen der Signalverkopplung benachbarte Leiterbahnen einen Mindestabstand (in der Regel ungefähr die Leiterbahnbreite) nicht unterschreiten.

Für die Realisierung solcher Verdrahtungen in Form von Leiterplatten bedeuten diese Wiederholungen der Verdrahtungsmuster sowie deren Spiegelungen in den Einzellagen eine wesentliche Verringerung des Aufwandes beim Erstellen des Layouts.

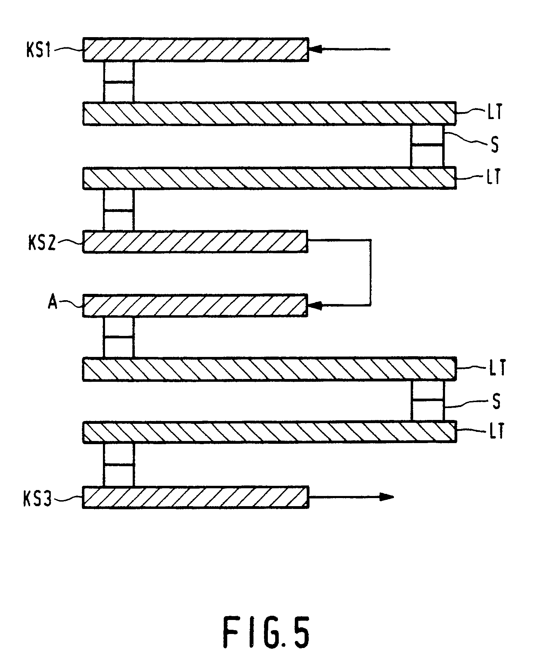

In Fig. 5 ist das Breitband-Raumvielfachkoppelfeld gemäß der Erfindung in Schnittdarstellung angegeben. Die Verkürzung der Zwischenleitungsabschnitte in horizontaler Richtung ermöglicht eine Steckverbindung S am Ende des Abschnitts A und damit eine Reduzierung der Maße der Leiterplatte L in einer Richtung. Der Platzbedarf für den Gesamtaufbau eines mehrstufigen Breitband-Raumvielfachkoppelfelds läßt sich dadurch verringern, daß die Leiterplattenteile LT als Träger für die einzelnen Koppelfeldstufen KS verwendet werden.

Falls der Aufbau des Breitband-Raumvielfachkoppelfeldes mittels baugleicher Leiterplatten durchgeführt werden soll, ist am Ausgang der zweiten Koppelfeldstufe KS2 ein Adapter A anzuordnen, welcher die Ausgänge dieser Stufe mit den Eingängen der nachfolgenden Leiterplatte L bzw. LT verbindet.

Das erfindungsgemäße Breitband-Raumvielfachkoppelfeld ist fertigungstechnisch einfach herzustellen, erfordert einen geringen Raumbedarf für den Gesamtaufbau und kann auch zum Aufbau großer Raummultiplex-Koppelfelder eingesetzt werden. Der Integrationsgrad der Koppelvielfache ist auf überraschend einfache Art und Weise nicht mehr durch die erforderliche Verdrahtung mit den Koppelvielfachen benachbarter Koppelstufen begrenzt. Der Aufbau eines breitbandigen Glasfasernetzes für neuartige Kommunikationsformen (Breitband-ISDN), insbesondere eines integrierten Breitbandfernmeldenetzes IBFN, mit hoher Teilnehmeranschlußzahl ist durch das erfindungsgemäße Breitband-Raumvielfachkoppelfeld ermöglicht.

## Ansprüche

1. Breitband-Raumvielfachkoppelfeld mit Zwischenleitungsführung in einer Leiterplatte (L) mit mehrlagigen Leiterbahnen in Mikrostrip-Technik zur Verdrahtung der Koppelvielfache (Mn(I), Mn(II)...) benachbarter Koppelstufen (KS1, KS2...), gekennzeichnet durch eine kanonische Zwischenleitungsführung unter Verwendung der Leiterplatte (L) derart, daß zu Gruppen zusammengefaßte Zwischenleitungsabschnitte des Koppelvielfachs (z.B. $M_1(I)$) jeweils auf eine Leiterbahnebene (L1, L2...) der Leiterplatte (L) aufgefächert sind.

2. Breitband-Raumvielfachkoppelfeld nach Anspruch 1, da durch gekennzeichnet , daß bei Verwendung einer Leiterplatte (L) mit zwei Leiterbahnebenen (L1, L2) ein Teil der benachbarten Zwischenleitungsabschnitte der ersten und der andere Teil der zweiten Gruppe zugeordnet ist.

3. Breitband-Raumvielfachkoppelfeld nach Anspruch 1, da durch gekennzeichnet , daß zur Erzielung gleicher Leitungslänge in jedem Abschnitt, die Zwischenleitungen in jeder Leiterbahnebene (L1, L2...) kreuzungsfrei und bis auf eine Zwischenleitung gekrümmt verlaufen.

4. Breitband-Raumvielfachkoppelfeld nach Anspruch 3, da durch gekennzeichnet , daß abschnittsweise die in jeder Leiterbahnebene (L1, L2...) geradlinig verlaufenden Zwischenleitungen bezüglich der Horizontalen den gleichen Winkel $\alpha$ einschließen und zueinander spiegelverkehrt verlaufen und daß abschnittsweise die übrigen Zwischenleitungen jeder Leiterbahnebene (L1, L2) am Anfang parallel zur Zwischenleitung der anderen Leiterbahnebene (z.B. L2) und danach parallel zur Zwischenleitung dieser Leiterbahnebene (z.B. L1) verlaufen.

5. Breitband-Raumvielfachkoppelfeld nach Anspruch 1, da durch gekennzeichnet , daß die Leiterplatte (L) mindestens zweiteilig ausgeführt ist und daß das erste Leiterplattenteil (LT) nur den ersten Abschnitt von Zwischenleitungen trägt.

6. Breitband-Raumvielfachkoppelfeld nach Anspruch 5, da durch gekennzeichnet , daß zur Verbindung der Leiterplattenteile (LT) Steckverbindungen (S) vorgesehen sind.

## Claims

1. Broadband space-division switching network with linkage in a printed circuit board (L) having multilayer lines in micro-strip technology for wiring the switching matrices (Mn(I), Mn(II), ...) of adjacent switching stages (KS1, KS2, ...), characterized by a canonical linkage utilizing the printed circuit board (L) such that grouped link sections of the switching matrix (for example, $M_1(I)$) are each time fanned out on a layer of a printed line (L1, L2, ...) of the printed circuit board (L).

2. Broadband space-division switching network as claimed in Claim 1, characterized in that when utilizing a printed-circuit board (L) having two line layers (L1, L2) one portion is assigned to the adjacent link section of the first group and the remaining Portion is assigned to the second group.

3. Broadband space-division switching network as claimed in Claim 1, characterized in that for obtaining an equal line length in each section, the links in each line layer (L1, L2, ...) are non-intersecting and show a bend except for one link.

4. Broadband space-division switching network as claimed in Claim 3, characterized in that per section the links running rectilinearly in each printed line layer (L1, L2, ...) enclose the same angle a relative to the horizontal and show a mirror-inverted pattern with respect to each other and in that per section the remaining links of each printed line layer (L1, L2) initially run parallel to the link of the other printed line layer (for example L2), and subsequently parallel to the link of the former printed line layer (for example L1).

5. Broadband space-division switching network as claimed in Claim 1, characterized in that the printed circuit board (L) is composed of no less than two portions and the first portion of the board (LT) carries only the first link section.

6. Broadband space-division switching network as claimed in Claim 5, characterized in that plug-in connectors (S) are provided to connect the portions of the printed circuit board (LT).

## Revendications

1. Champ de connexion à multiplexage spatial à larges bandes dans lequel le tracé des chaînons de voie est réalisé dans une plaquette de circuits imprimés (L,) à pistes conductrices multicouches par la technique dite microstrip ou microruban pour le câblage des matrices de connexion (Mn(I), Mn(II), ...) d'étages de connexion (KS1, KS2, ...) voisins, caractérisé par un tracé de chaînons de voie canonique utilisant la plaquette de circuits imprimés (L) d'une manière telle que des sections de chaînons de voie de la matrice de connexion (par exemple $M_1(I)$) réunies en groupe sont chaque fois distribuées en éventail sur un plan de pistes conductrices (L1, L2,...) de la plaquette de circuits imprimés (L).

2. Champ de connexion à multiplexage spatial à large bande suivant la revendication 1, caractérisé en ce que, lors de l'utilisation d'une plaquette de circuits imprimés (L,) à deux plans de pistes conductrices (L1, L2), une partie des sections de chaînons de voie voisines est associée au premier groupe et l'autre partie est associée au deuxième groupe.

3. Champ de connexion à multiplexage spatial à larges bandes suivant la revendication 1, caractérisé en ce qu'en vue de l'obtention de conducteurs de mêmes longueurs dans chaque section, les chaînons de voie ont, dans chaque plan de pistes conductrices (L1, L2, ...) un parcours qui est exempt de croisements et qui, sauf pour l'un des chaînons de voie, est courbe.

4. Champ de connexion à multiplexage spatial à large bande suivant la revendication 3, caractérisé en ce que par section, les chaînons de voie, ayant dans chaque plan de pistes conductrices (L1, L2, ...) un parcours linéaire, forment avec l'horizontale le même angle inclus a et sont mutuellement énantiomorphes et que, par section, les autres chaînons de voie de chaque plan de pistes conductrices (L1, L2) sont initialement parallèles au chaînon de voie de l'autre plan de pistes conductrices (par exemple L2) et ensuite parallèles au chaînon de voie du plan de pistes conductrices en question (par exemple L1).

5. Champ de connexion à multiplexage spatial à larges bandes suivant la revendication 1, caractérisé en ce que la plaquette de circuits imprimés (L) est réalisée en au moins deux parties et que la première partie de plaquette de circuits imprimés (LT) ne porte que la première section des chaînons de voie.

6. Champ de connexion à multiplexage spatial à large bande suivant la revendication 5, caractérisé en ce que des connexions à enficher (S) sont prévues pour relier les parties de plaquettes de circuits imprimés (LT).

FIG.1

FIG. 2

FIG. 3

FIG.4

KS1

LT
S
LT

KS2

A

LT
S
LT

KS3

# FIG.5